# EUROPEAN PATENT SPECIFICATION

(11) **EP 3 093 309 B1**
(45) Date of publication and mention of the grant of the patent: **21.03.2018**
(21) Application number: 15167194.8
(22) Date of filing: 11.05.2015
(51) Int. Cl.: C08J 7/04, C08J 7/06, C23C 16/26, C23C 16/34

(54) **PROCESS FOR DEPOSITING A GAS BARRIER COATING ON A POLYMER FILM OR POLYMER CONTAINER, AND POLYMER FILM OR POLYMER CONTAINER WITH COATED WITH SUCH A GAS BARRIER**
VERFAHREN ZUM AUFBRINGEN EINER GASSPERRSCHICHT AUF EINE POLYMERFOLIE ODER EINEN POLYMERBEHÄLTER UND POLYMERFOLIE ODER POLYMERBEHÄLTER MIT SOLCH EINER GASSPERRE
PROCÉDÉ DE DÉPÔT D'UN REVÊTEMENT DE BARRIÈRE AUX GAZ SUR UN FILM POLYMÈRE OU RÉCIPIENT EN POLYMÈRE ET FILM POLYMÈRE OU RÉCIPIENT EN POLYMÈRE REVÊTU D'UNE TELLE BARRIÈRE AUX GAZ

(43) Date of publication of application: 16.11.2016
(73) Proprietor: Coating Plasma Industrie, 13790 Peynier (FR)
(72) Inventor: Viard, Jocelyn, 13960 SAUSSET-LES-PINS (FR)
(74) Representative: Schmidt, Martin Peter

(56) References cited:
- JP-A- H11 245 327
- US-A1- 2012 205 279
- US-B1- 6 322 880

## Description

### Technical field of the invention

The present invention relates generally to the field of polymer films and polymer containers. In particular it relates to polymer films and polymer containers that need to exhibit certain barrier properties with respect to certain gases, such as water vapor, oxygen, carbon dioxide. Such polymer films and polymer containers are used in packaging for protecting solid, semi-solid or liquid goods against ambient air or other ambient conditions; such goods can be food and beverage products. In particular, the present invention relates to polymer films and polymer containers coated with a gas barrier coating comprising a first layer of hydrogenated amorphous silicon nitride and a second layer of hydrogenated amorphous carbon. The hydrogenated amorphous silicon nitride layer may be deposited on the container, and the hydrogenated amorphous carbon layer may be deposited on the hydrogenated amorphous silicon nitride layer. A further aspect of the invention is a process for coating polymer films or polymer containers comprising the steps of depositing a layer of hydrogenated amorphous silicon nitride on a polyolefin container by plasma-enhanced chemical vapour deposition and depositing a layer of hydrogenated amorphous carbon on the hydrogenated amorphous silicon nitride layer by plasma-enhanced chemical vapour deposition.

### State of the art

Polymers such as polyolefines (especially polyethylene (PE) and polypropylene (PP)) or polyethylene terephthalate (PET) are widely used in food packaging due to their lightness, low cost and flexibility. However, many polymer materials, and most polyolefin materials, have low gas barrier properties, allowing oxygen or carbon dioxide molecules to easily penetrate packaging formed from such polymer materials. For this reason, most plastic carbonated drink bottles are formed from polyethylene terephthalate (PET) rather than a polyolefin, as PET has much better gas barrier properties. As well as a need to keep gasses in the container, there may be a need to exclude gases, for example excluding oxygen can prevent a loss of quality due to oxidation of the container's contents. Gas barrier properties of a given polymer material can be different from one polymer material to another, and for a given polymer material, can be different from one gaseous species to another.

One approach to increase the gas barrier properties of polymer materials is to laminate the polymer material with other materials providing barrier properties. A polymer such as ethylene-vinyl alcohol (EVAL EvOH) provides a good oxygen barrier, but it is detrimentally affected by moisture and so must be sandwiched between other layers of material to protect it from moisture. To form containers such as boxes, bottles and capsules, a polyolefin polymer may be extruded together with a high oxygen barrier polymer and then blow-formed into a bottle or other container shape. However, multi-layer co-extrusion is relatively expensive, and containers formed from mixtures of plastics cannot easily be recycled, and so have a high environmental impact. Thin evaporated metal layers are as used as gas barriers on polymer films. Consumers are more and more concerned about recyclability and excess of packaging. At the same time, they are not ready to compromise on the product quality and convenience. There is therefore a need to provide polymer films and polymer containers, and in particular polyolefin films, which has good gas barrier properties but which is predominantly a single polymer material and so can be more easily recycled.

Attempts have been made to apply a very thin layer of barrier material to plastic films and plastic containers, for example by plasma coating. This has the advantage that the final coated film or container has a lower environmental impact due to the minimum consumption of barrier materials and the fact that it can be considered as a mono material and so can be more easily recycled.

A wide range of materials have been described as barrier layers. JP 11 245 327 A describes a protective double layer comprising a SiO₂ film deposited on a PET substrat by RF reactive sputtering, covered by a diamond-like carbon (DLC) film deposited by plasma CVD. US 6 322 880 B1 describes the deposition of a dual protective double layer on magnetic recording media comprising a SiNₓ layer covered with a layer of an a-C:H or an a-C:H_{b}N_{c}. AU 2011236081 A describes a catalytic CVD process for depositing a gas barrier inside a plastic container. A carbon thin film may be deposited using acetylene, while a mixture of silane, ammonia and hydrogen can be used for depositing a silicon nitride thin film. US 2008/017113 and EP 1 652 961 A1 describe different chemical vapour deposition (CVD) methods for depositing a barrier layer (SiOₓ or DLC or silicon nitride) onto the inner wall of a plastic container. WO 2013/041469 describes the deposition of metal films, carbon films or ceramic oxide films (SiOₓ, AlOₓ) by physical vapour deposition or plasma-enhanced chemical vapour deposition; more complex silicon-oxide-based compositions such as SiOₓC_{y} and SiOₓC_{y}N_{z} are also described. EP 1 283 179 A1 describes other barrier layer coatings including silicon nitride, aluminium oxide and DLC that are applied on PET-paper laminates or on EVOH-paper laminates.

Plastic containers covered with bilayers comprising silicon oxide and either silicon carbide or silicon nitride are disclosed in JP 2003-104352. More specifically, US 2002/0179603 discloses a device that allows the internal or external face of a plastic bottle to be covered with a barrier coating. Plasma-deposited hydrogenated amorphous carbon is used as a coating for PET and polyolefin containers. Depending on the permeability of the polymer film, this may not result in satisfactory barrier properties. In particular, polyolefin containers present a greater challenge, not just because of the higher permeability of the polymer, but also due to the poor adhesion and susceptibility to pin-holes and cracks in the coating when applied on a polyolefin surface. US 2004/0076836 proposes a gas barrier coating deposited on a PET substrate by low pressure plasma. An interface layer comprising silicon, carbon, oxygen, and hydrogen is deposited from an organosilicon compound and covered with a protective layer of SiOₓ or hydrogenated amorphous carbon. US 2012 / 0 205 279 A1 describes a method for coating the inner or outer surface of a plastic container with thin films (5 to 100 nm) of a SiNₓ:H, a hydrogen-containing DLC, a SiOₓ:H or a SiCₓN_{y}:H. WO 2006/044254 describes a method for coating the inside surface of a polyolefin or a polylactic acid container to provide an effective barrier against gas transmission. Thin layers of polyorganosiloxane and silicon oxide are deposited by a plasma process. EP 2 363 511 discloses a polymer film which has a silicon nitride layer deposited on its surface to act as a gas barrier. The silicon nitride layer is formed by plasma coating with gas mixtures such as silane gas, ammonia gas and hydrogen gas, or silane gas and nitrogen gas. EP 2 551 216 describes a container with a plasma coated barrier layer deposited onto parts of its surface. In order to prevent coating on certain parts of the container surface, for example internal filters or membranes to close the container, masks are used. The need to mask certain areas of the container adds complexity to the coating process, and increases the risk of an incomplete barrier being formed, leading to leaks.

In order to obtain satisfactory barrier properties, barrier layers must be sufficiently thick. As an example, WO 2006/007313 describes barrier layers selected from SiN, SiON, SiO and SiC with a thickness comprised between 500 Å and 500 000 Å, and preferably between 2 000 Å and 50 000 Å. A thickness of 80 nm to 200 nm is recommended in US 2004/0076836 for mixed layers containing Si, N, O and H. Thinner ceramic coatings (5 nm to 50 nm) on flexible polymer films are described in WO 2013/041469 and JP 2003-104352. For diamond-like carbon films and silicon-containing gas barrier films deposited by CVD a thickness between 10 nm and 200 nm has been recommended in EP 1 652 961 A1. The quality of the films depends also on the deposition technique and the film growth rate. It is desirable to choose a deposition technique allowing to obtain thin films of good film quality with a high deposition rate.

An object of the present invention is to improve the state of the art and to provide improved polymer films and polymer containers coated with a gas barrier coating to overcome at least some of the inconveniences described above or at least to provide a useful alternative.

### Subject-matter of the invention

The present invention relates to a polymer film or polymer container coated with a gas barrier coating according to claim 1, a coating process according to claim 10 and use of the polymer film or polymer container according to claims 13-15.

According to the present disclosure the problem is solved by a polymer film or polymer container coated with a gas barrier coating, wherein said gas barrier coating comprises a first layer of hydrogenated amorphous silicon nitride deposited onto said polymer film or polymer container, and a second layer of hydrogenated amorphous carbon deposited onto said hydrogenated amorphous silicon nitride layer, and wherein said gas barrier coating has a thickness of between 2 nm and 25 nm, preferably between 2 nm and 20 nm, and even more preferably between 2 nm and 15 nm.

The inventors surprisingly found that by coating a polymer film or polymer container with a first layer of hydrogenated amorphous silicon nitride and a second layer of hydrogenated amorphous carbon they could achieve better gas barrier properties than by conventional coatings such as layers of silicon oxide. Multiple layers of film coating are conventionally applied to improve the gas barrier properties, each layer covering any tiny gaps left by the previous layer. A problem with this approach is that the thicker the final film coated layer, the more likely it is to crack and develop leaks. The inventors surprisingly found that with a first layer of hydrogenated amorphous silicon nitride and a second layer of hydrogenated amorphous carbon they could achieve a good gas barrier with a thin film. Having a thin barrier layer reduces problems of cracking and reduces barrier cost.

In an advantageous embodiment of the invention, said first layer of hydrogenated amorphous silicon nitride has a thickness of between 1 nm and 15 nm, preferably between 2 nm and 15 nm, and still more preferably between 2 nm and 10 nm. In one embodiment, the thickness of said first layer is comprised between about one third and about two thirds of the total thickness of the gas barrier layer, in order to ensure good gas barrier properties.

Polyolefin containers are explicitly disclaimed from the scope of protection of the present invention, and this applies to any subject-matter and any category of claims that could possibly be derived from the present application. A polyolefin container is a container whose material of construction predominantly comprises polyolefin. Polyolefins (or polyalkenes) are polymers produced from simple olefins (also called alkenes) as monomer. Examples of polyolefins include polyethylene (PE), polypropylene (PP), polymethylpentene and poly(1-butene).

The coated polymer film or container according to the invention advantageously have an oxygen transfer rate per m² of film surface or container surface of less than 6 cm³ of oxygen per day at 1 bar pressure and 100% oxygen. In the coated polymer films according to the invention the polymer is advantageously selected from the group formed by: polyolefins (preferably polyethylene (PE) or polypropylene (PP)), polyesters (preferably polyethylene terephthalate (PET) or polybutylene terephthalate), polystyrenes (preferably polystyrene (PS), styrene-butadiene rubber (SBR), acrylonitrile-butadiene-styrene copolymers (ABS)), polyamides (PA), polyimides, fluorinated polymers (preferably polytetrafluoroethylene (PTFE), ethylene polytetrafluoroethylene (ETFE), ethylene chlorotrifluoroethylene (ECTFE)), polyvinylchloride (PVC), biopolymers (preferably polylactic acid, cellulose, starch), cellulosic polymers.

In the coated polymer containers according to the invention the polymer is advantageously selected from the group formed by: polyesters (preferably polyethylene terephthalate (PET) or polybutylene terephthalate), polystyrenes (preferably polystyrene (PS), styrene-butadiene rubber (SBR), acrylonitrile-butadiene-styrene copolymers (ABS)), polyamides (PA), polyimides, fluorinated polymers (preferably polytetrafluoroethylene (PTFE), ethylene polytetrafluoroethylene (ETFE), ethylene chlorotrifluoroethylene (ECTFE)), polyvinylchloride (PVC), biopolymers (preferably polylactic acid, cellulose, starch), cellulosic polymers.

The coated polymer containers according to the invention can be injection-moulded. Advantageously at least 99 % of the internal surface and/or at least 99 % of the external surface of the polymer container is coated with said gas barrier coating. These containers can be closed by a membrane sealed to the container in a gas and moisture tight manner; said membrane can be a metal film or a polymer film, and if a polymer film is used, said polymer film is preferably a coated polymer film according to the invention.

Containers according to the invention can be selected from the group consisting of a bottle, a tray, a cup or a capsule.

Another subject-matter of the present disclosure is a process for coating a polymer film or polymer container comprising the steps:
(a) depositing a layer of hydrogenated amorphous silicon nitride on said polymer film or polymer container by plasma-enhanced chemical vapour deposition,
(b) depositing a layer of hydrogenated amorphous carbon on said hydrogenated amorphous silicon nitride layer by plasma-enhanced chemical vapour deposition,
wherein said gas barrier coating has a thickness of between 2 nm and 25 nm, preferably between 2 nm and 20 nm, and even more preferably between 2 nm and 15 nm, and as mentioned above with the proviso that said polymer container is not a polyolefin container.

In said process, said hydrogenated amorphous silicon nitride layer can be deposited by plasma-enhanced chemical vapour deposition of a mixture of silane and nitrogen, and/or said hydrogenated amorphous carbon layer can be deposited by plasma-enhanced chemical vapour deposition of ethyne. Deposition rates are preferably comprised between 5 nm/min and 25 nm/min (and still more preferably between 10 nm/min and 20 nm/min) for the amorphous hydrogenated silicon nitride layer, and between 50 nm/min and 200 nm/min (and preferably between 75 nm/min and 200 nm/min, and still more preferably between 100 nm/min and 175 nm/min) for the amorphous hydrogenated carbon layer.

During the deposition the substrate temperature is advantageously below 130°C, preferably below 115°C and still more preferably below 50°C.

In a variant of said process, a pre-treatment is applied to the polymer film or polymer container with a plasma of argon before deposition of the hydrogenated amorphous silicon nitride layer.

The invention also relates to the use of polymer films or coated polymer containers according to the invention. Accordingly, another subject-matter of the invention is the use of a coated polymer container according to the invention (excluding polyolefin containers) for the storage of food or beverage materials.

Still another subject-matter of the invention is the use of a coated polymer container according to the invention (excluding polyolefin containers) as a film-sealed food tray.

A last subject-matter of the invention is the use of a coated polymer film according to the invention for the manufacture of containers or packaging for the storage of food or beverage materials (excluding polyolefin containers).

Any reference to prior art documents in this specification is not to be considered an admission that such prior art is widely known or forms part of the common general knowledge in the field. As used in this specification, the words "comprises", "comprising", and similar words, are not to be interpreted in an exclusive or exhaustive sense. In other words, they are intended to mean "including, but not limited to".

### Brief description of the figures

Figure 1 is a side view drawing of a polymer container to be coated.
Figure 2 is represents the arrangement of containers in the plasma-enhanced chemical vapor deposition apparatus.
Figure 3 is a drawing showing how containers were prepared for oxygen transmission rate measurement.

### Detailed description

The present invention relates to polymer films and polymer containers coated with a gas barrier coating comprising a first layer of hydrogenated amorphous silicon nitride and a second layer of hydrogenated amorphous carbon; the hydrogenated amorphous silicon nitride layer being deposited on the container, and the hydrogenated amorphous carbon layer being deposited on the hydrogenated amorphous silicon nitride layer.

The size and shape of the container is not particularly limited, it may be for example a cup, a bottle, a tray, a box or a capsule. Gas barrier coatings are applied to materials such as plastics to reduce gas permeability.

The term "gas barrier" as used hererin refers in particular to oxygen which is the gas that needs to be kept away from foodstuff and other air sensitive products in order to improve the shelf life of packagings made from polymer materials cated with such gas barriers.

In the scope of the current application, amorphous hydrogenated silicon nitride refers to amorphous compounds of silicon and nitrogen with the general formula SiNₓ:H (also called a-SiNₓ:H the "a" meaning "amorphous"). The silicon nitride in the coating is not exactly stoichiometric, the value for x may vary between 0.5 and 1.5. The atomic concentration of hydrogen in the amorphous hydrogenated silicon nitride may typically be less than 20 at. %, for example less than 10 at. %, for further example less than 5 at. %.

Amorphous carbon is free, reactive carbon that does not have any crystalline structure, as shows by X-ray diffraction. Amorphous carbon materials may be stabilized with hydrogen. Such materials are then called hydrogenated amorphous carbon, C:H (also called a-C:H, the "a" meaning "amorphous").

The polymer film or polymer container of the invention may be coated with a gas barrier coating consisting of a first layer of hydrogenated amorphous silicon nitride and a second layer of hydrogenated amorphous carbon; the hydrogenated amorphous silicon nitride layer being deposited on the container, and the hydrogenated amorphous carbon layer being deposited on the hydrogenated amorphous silicon nitride layer. The atomic concentration of hydrogen in the hydrogenated amorphous carbon may be less than 20 at. %, for example less than 10 at. %, for further example less than 5 at. %. The hydrogenated amorphous carbon layer may be the outer layer of the coating. The hydrogenated amorphous carbon protects the coating from damage caused by abrasion.

The inventors were surprised to find that the gas barrier coating according to the invention was able to provide good barrier properties at low thicknesses. The thickness of the coating can be measured by electron microscopy, for example bright field transmission electron microscopy (TEM-BF). The gas barrier coating of the invention may have a thickness of between 2 nm and 25 nm, for example between 3 nm and 20 nm, for further example between 6 nm and 15 nm. Where the film or container is coated on two sides, the thickness refers to the thickness of the coating on each side. Such thin bilayers provide excellent barrier properties and do not have a detrimental effect on the recycling of the polymer and are less susceptible to cracking. A thickness greater than 20 nm is not useful and may lead to cracks on certain substrates; a thickness exceeding 25 nm should generally be avoided for these bilayers.

The polymer container may be coated on the inside, on the outside or both. Coating both inside and outside has the advantage of that if a section of the coating is damaged, for example by abrasion, then the gas barrier will be maintained by the coating on the other side of the container wall. Other components such as sealing membranes may be affixed directly to the gas barrier coating of the present invention, for example by ultrasonic sealing. This avoids the need to leave parts of the container uncoated to apply the sealing membrane. Having a complete coating reduces the risk of leaks, for example even a slight misalignment of a mask intended to leave an uncoated region for a sealing membrane could cause a leak. As the container needs to be held in position during the coating process, the contact points between the container and the fixing means will necessarily not be coated. These contact points should be designed to be small, and positioned on a part of the container where a gas barrier is either not required, or is provided in another way. For example the contact point might be on a flange around the neck of a bottle, or the contact point might be a small area within the region where a seal is to be applied. At least 99 % of the internal surface and/or at least 99 % of the external surface of the polymer container may be coated with the gas barrier coating.

The polymer container according to the invention may be formed by any of the methods well known in the art. For example it may be thermoformed, blow moulded, injection moulded or injection blow moulded. In particular, the polymer container according to the invention may be injection-moulded. Injection moulding consists of high pressure injection of a raw material, for example a polymer, into a mould which shapes the material into the desired shape. The material is usually heated before the high pressure injection and then cooled in the mould to solidify it. Injection moulding is the leading method of manufacturing wide mouth thermoplastic tubs, boxes and complex dimensional shapes. Because the part dimensions are completely controlled by the mould surfaces, injection moulding gives a dimensionally accurate part. Thin walled plastic containers can be manufactured, for example with wall thicknesses of around 0.15 mm.

The polymer forming the polymer container of the present disclosure may be selected from polyesters (preferably polyethylene terephthalate (PET) or polybutylene terephthalate), polystyrenes (preferably polystyrene (PS), styrene-butadiene rubber (SBR), acrylonitrile-butadiene-styrene copolymers (ABS)), polyamides (PA), polyimides, fluorinated polymers (preferably polytetrafluoroethylene (PTFE), ethylene polytetrafluoroethylene (ETFE), ethylene chlorotrifluoroethylene (ECTFE)), polyvinylchloride (PVC), but polyolefin containers are disclaimed from the scope of the present invention.

The polymer forming the polymer film of the invention may be any of the polymers mentioned in relation with the container, and in addition may be selected among the polyolefines. The polyolefin forming the polymer film of the invention may be a homopolymer with a purity of at least 99 % by weight. In particular it can be polypropylene. Polypropylene is any homopolymer or copolymer in which propylene is the major component monomer. Polypropylene's inherent stiffness makes it ideal for thin walled packaging items. A high purity polypropylene can advantageously be used. This avoids low molecular weight additives migrating to the surface of the container and interfering with the application of the barrier coating. The polypropylene may have a semicrystalline or crystalline structure.

The polymer film or polymer container coated with a gas barrier coating of the invention has a low permeability to oxygen. Excluding oxygen can be valuable in preventing degradation of the contents of a container. For example many foodstuffs undergo oxidation leading to undesirable colour and flavour changes, and excluding oxygen can prevent growth of a number of food spoilage organisms. A polymer film or polymer container coated with a gas barrier coating according to the invention may have an oxygen transfer rate of less than 0.02 cm³ of oxygen per day at 1 bar pressure and 100% oxygen, for example less than 0.01 cm³ of oxygen per day at 1 bar pressure and 100% oxygen, for further example less than 0.005 cm³ of oxygen per day at 1 bar pressure and 100% oxygen. The oxygen transfer rate per m² of film surface or container surface may be less than 6 cm³ of oxygen per day at 1 bar pressure and 100% oxygen, for example less than 3 cm³ of oxygen per day at 1 bar pressure and 100% oxygen, for further example less than 2.5 cm³ of oxygen per day at 1 bar pressure and 100% oxygen.

The polymer container according to the invention may be sealed by any method well known in the art and suitable for the type of container. For example, the container may be a yoghurt pot and a plastic-coated aluminium foil lid may be heat-sealed onto the opening of the pot, the container may be a tray such as a food tray, hermetically sealed with a film, or the container may be a bottle with a screw neck, and a lid may be screwed onto the bottle to close it. Such a lid will also need to have good gas barrier properties to protect the contents of the container, so for example a moulded polyolefin lid may also be coated with a gas barrier coating in a similar way to the container of the invention. The polymer container according to the invention may be closed by a membrane sealed to the container in a gas and moisture tight manner. Multilayer film and/or a plasma coated film can be used. The polymer container according to the invention may be selected from the group consisting of a bottle, a tray, a cup or a capsule. The polymer container according to the invention may be a rigid container or a semi-rigid contained.

One aspect of the present disclosure is a process for coating a polymer film or a polymer container comprising the steps of:
a) depositing a layer of hydrogenated amorphous silicon nitride on a polymer film or polymer container by plasma-enhanced chemical vapour deposition,
b) depositing a layer of hydrogenated amorphous carbon on the hydrogenated amorphous silicon nitride layer by plasma-enhanced chemical vapour deposition,
the total thickness of both layers being comprised between 2 nm and 25 nm.

Plasma-enhanced chemical vapour deposition (PECVD) is a process used to deposit thin films from a gas state to a solid state on a substrate; this process is known in the art. Chemical reactions occur after creation of a plasma of the process gases. Plasma assisted chemical vapour deposition is an equivalent term to PECVD.

Plasma is a partially ionized gas containing ions, electrons, atoms, and neutral species. In order to excite and sustain excitation state, a voltage must be applied to the plasma. The voltage is usually applied by using an radio frequency (RF) signal between two electrodes, the space between which is filled with the process gases. To enable the gas to be ionized in a controlled manner, the process is carried out under vacuum conditions.

PECVD permits energetic reactions at low temperatures (as low as 100 °C in some cases) as the plasma is formed by electrical ionization. This is an advantage over film coating techniques which form reactive gases using heat, such as combustion chemical vapour deposition or hot-wire chemical vapour deposition (also known as catalytic chemical vapour deposition). Heat can lead to deformation of the material being coated, which in turn may cause cracks in the coating layer. Heat may also cause degeneration of the material to be coated, such as depolymerisation. In the process of the present invention, deposition may occur at a temperature below 130 °C, and preferably below 50°C. This is especially important for those polymers that are particularly sensitive to being deformed or damaged by high temperatures due to their low glass transition temperature and high thermal expansion, such polyolefin films (for example PP films). In fact, during film deposition the substrate surface is heated by the plasma, and it is therefore advantageous to provide cooling means for at least the electrodes which otherwise may heat up during the continuous use of the machine.

The polymer films and polymer containers coated with a gas barrier coating may be obtainable by a process for coating a polyolefin container comprising the steps:
a) depositing a layer of hydrogenated amorphous silicon nitride on a polyolefin container by plasma-enhanced chemical vapour deposition,
b) depositing a layer of hydrogenated amorphous carbon on the hydrogenated amorphous silicon nitride layer by plasma-enhanced chemical vapour deposition,
the total thickness of both layers being comprised between 2 nm and 25 nm.

The layer of hydrogenated amorphous silicon nitride and the layer of hydrogenated amorphous carbon may be deposited in the same reactor chamber by changing the process gas between deposits, or the polymer films or polymer container may be coated with hydrogenated amorphous silicon nitride in one reactor chamber and then transported to a second reactor chamber for the coating with hydrogenated amorphous carbon. The process may be operated as a continuous or semi-continuous process, for example by transporting the containers through the chambers sequentially, using a series of air-locks separating chambers containing different plasma gasses. Continuous deposition processes are particularly useful for deposition on polymer films and can be carried out as a roll-to-roll process.

The inventors were surprised to find that such a thin bilayer is sufficient to ensure good barrier properties. While the inventor do not wish to be bound by this theory, they believe that the choice of the two layers forming the bilayer is critical. Amorphous hydrogenated silicon nitride can be deposited as a very dense inorganic layer, having about three nitrogen atoms surrounding a pyramidal tetravalent silicon atom (while in silicon oxide layers there are only two oxygen atoms per silicon atom). Amorphous hydrogenated carbon is a dense, non polymeric layer having tetravalent carbon atoms. The amorphous hydrogenated carbon layer improves the barrier properties of the amorphous silicon nitride layer on which it is deposited; amorphous hydrogenated carbon films exhibit poor barrier properties if deposited directly onto the polymeric substrate under these conditions. If the bilayer is too thick there will be a risk of microcracks which will decrease both the barrier properties and the durability of the barrier coating. Preferably in the bilayer according to the invention the amorphous hydrogenated silicon - nitride layer has a thickness of about 1 nm to 15 nm, preferably of about 2 nm to 15 nm, and still more preferably of about 2 nm to 10 nm.

In the process of the invention, a single layer of hydrogenated amorphous silicon nitride and a single layer of hydrogenated amorphous carbon may be deposited. Conventionally it is expected that having only one or two PECVD layers on a film leads to pinholes in the coating whereas, by applying additional layers, any pinholes which may be present in a particular layer of coating will be covered by the overlapping and subsequent layers. However, the inventors were surprised to find that low gas permeability could be obtained with a single layer of hydrogenated amorphous silicon nitride and a single layer of hydrogenated amorphous carbon.

However, using two or more layers of the same kind (i.e. two or more superposed hydrogenated amorphous carbon layers and/or two or more amorphous hydrogenated silicon nitride layers) is fully within the scope of the present invention, provided that the specified thickness range is met.

In a variant of the process a continuous transition is made between the silicon nitride layer and the carbon layer, i.e. the layer exhibits a gradient of Si, N, C, and H between the hydrogenated amorphous silicon nitride layer and the hydrogenated amorphous carbon layer.

Different process gases (also called precursor gases) may be used in a PECVD process to form silicon nitride, such as a mixture of hexamethyldisilazane, silane, ammonia and nitrogen; this is known as such from US 5 508 067. Such carbon containing gas mixtures lead to the incorporation of carbon atoms in the film which has been found to reduce the gas barrier properties of the film. Mixtures of silane, ammonia and nitrogen or silane, nitrogen and argon may be used to produce silicon nitride films by PECVD, but the inventors found that a mixture of silane and nitrogen gases gave particularly good results in the process of the present invention. The term silane is sometimes used to refer to the family of saturated hydrosilicon compounds but in the present specification the term silane refers to the molecular species SiH₄. The hydrogenated amorphous silicon nitride layer may be deposited by plasma-enhanced chemical vapour deposition of a mixture of silane and nitrogen.

Different process gases may be used in a PECVD process to form amorphous carbon, for example mixtures of methane and argon, methane and nitrogen or ethyne and hydrogen. The inventors found that ethyne gas alone (no diluent gas) gave particularly good results in the process of the present invention. The hydrogenated amorphous carbon layer may be deposited by plasma-enhanced chemical vapour deposition of ethyne.

The deposition rate during the process according to the invention is advantageously comprise between 5 nm/min and 100 nm/min. The deposition rate of the first layer (amorphous hydrogenated silicon nitride) is especially critical and should be at least 10 nm/min. The deposition rate depends on the power of the plasma and the quantity of reactive gas. If the deposition rate is too low, the substrate may be damaged by the reactive plasma during the deposition of the first atomic layers, because the initial polymer surface is exposed to the plasma for a longer period of time. Furthermore, a slow deposition process will be less economic. At high deposition rates, internal stress may build up in the film and cracks may be formed. At high deposition rates there is also a risk of powder formation which will increase the density of pinholes in the film; a low pinhole density (or preferably the absence of pinholers) is a prerequisite for such thin bilayers being capable of acting as efficient gas barriers.

The process of the invention may further comprise pre-treating the polymer films or polymer container with a plasma of argon before deposition of the hydrogenated amorphous silicon nitride layer. For example, the polymer films or polymer container may be placed in a PECVD reactor which is then run with argon as the process gas. This pre-treatment cleans and activates the surface of the film or container which improves the quality of the subsequent coating. It should however be carried out in a way as to avoid functional damage to the substrate surface.

The polymer film or polyolefin container of the present disclosure may be used for the storage of food or beverage materials. For this purpose polymer films can be processed into pouches or any other form, and polymer containers can be provided with an appropriate closure. The storage life and quality of food and beverage materials can be improved by maintaining a modified atmosphere within the container or pouch in which they are stored, or by excluding gasses such as oxygen from within the storage container or storage pouch. Polymer containers or pouches are widely used as food and beverage containers, but depending on the polymer used for their manufacture, have different inherent gas barrier properties. The coated polymer container or polymer pouch of the invention, having good gas barrier properties, may beneficially be used to store food and beverage materials. For example, the polymer container of the invention may be used as a film-sealed food tray, said sealing film being preferable also a coated film according to the invention.

Those skilled in the art will understand that they can freely combine all features of the present invention disclosed herein. In particular, features described for the product of the present invention may be combined with the process of the present invention and vice versa. Further, features described for different embodiments of the present invention may be combined. Where known equivalents exist to specific features, such equivalents are incorporated as if specifically referred to in this specification. Further advantages and features of the present invention are apparent from the figures and non-limiting example.

### Examples

### Example 1 : prolypropylene films

Polypropylene (PP) films of 500 µm thick were plasma coated in a PECVD apparatus by Coating Plasma Industrie, Peynier, France. The PECVD reactor was fitted with a 40 kHz generator, a 1000 x 600 mm RF electrode and a 900 x 550 mm ground electrode. A Magnetron array was fixed below the ground electrode. There were two gas inlets; one fixed on the ground electrode and the other on the RF electrode.

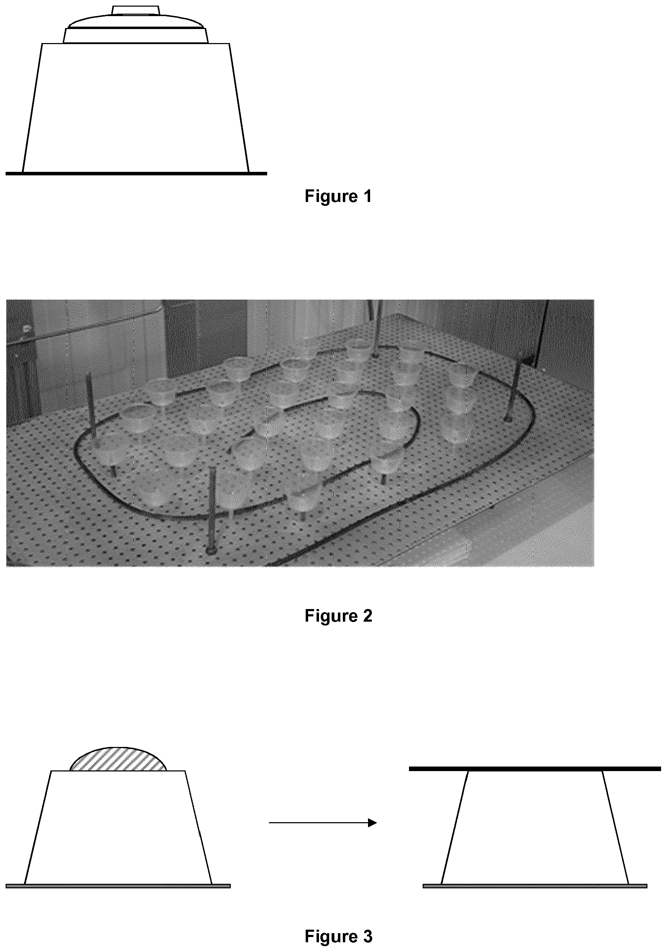

PP films were coated in a batch mode using different deposition times. For each set of conditions, the film was placed so as to be within approximately 7 cm from the ground electrode (Fig. 2). The reactor was evacuated to form a vacuum and then argon was flowed into the reactor at a flow rate of 1.0 standard litres per minute (slm). Plasma was generated for 10 s using a power of 1000 W. The gas flow was then changed to a mixture of SiH₄ (0.1 slm) and N₂ (2.0 slm) and, once the argon was purged from the reactor, plasma was generated for the deposition time shown in table 1 using a power of 1000 W to deposit a layer of hydrogenated amorphous silicon nitride on the film. The gas flow was then changed to C₂H₂ (0.4 slm) and, once the silane/nitrogen had been purged from the reactor, plasma was generated for the deposition time shown in table 1 using a power of 1000 W to deposit a layer of hydrogenated amorphous silicon nitride.

The oxygen transmission rate (OTR) was then measured at two locations from each set of conditions, one taken from the middle of the film and one from the edge. Two un-coated films were also measured. The OTR was measured using an OX-TRAN™ Model 2/61. The films were replaced by aluminum foil. The measurement period was 72 hours at 23 °C (30-40 % RH). Results are shown in table 1.

**Table 1**

| Sample | Treatment time | | | Middle | Edge |
|---|---|---|---|---|---|
| | Ar | a-Si_{X}N_{y}:H | a-C:H | OTR(*) | OTR (*) |
| Un-coated | - | - | - | 126.0 | 124.9 |
| A | 10s | 15s | 15s | 4.1 | 4.0 |
| B | 10s | 30s | 30s | 1.8 | 1.2 |
| C | 10s | 45s | 45s | 2.8 | 2.9 |
| (*) OTR results in cm³/m²/24h 100% O₂ | | | | | |

Under these conditions the best deposition time is 30 s. The sample with 30 s deposition (B) taken from the middle of the group had an oxygen transfer rate of per m² of film surface of 1.8 cm³ of oxygen per day at 1 bar pressure and 100% oxygen. Increasing the treatment time increases the film thickness, so it can be seen that once the film reaches a certain thickness, any further deposit is detrimental. An identical film coated by PECVD with multiple layers of polyorganosiloxane and silicon oxide (seven layers in total) was measured and found to have an OTR of 7.4 cm³/m²/24h at 100% O₂. This demonstrates that, by coating a polyolefin film with a first layer of hydrogenated amorphous silicon nitride and a second layer of hydrogenated amorphous carbon, a better gas barrier can be achieved than by conventional coatings such as multiple layers of polyorganosiloxane and silicon oxide.

The same deposition process has been successfully used to coat plastic containers, as shown on figures 1 to 3. For measuring the OTR the bottoms of the capsules were cut off and replaced by aluminum foil, glued to the capsules (see figure 3).

### Example 2 : Coating on various polymers films

In the same reactor two different polymer films (polypropylene (thickness 20 µm) and PET (thickness 12 µm)) were coated using the same treatment deposition times : Argon treatment 10s, a-SiₓN_{y}:H deposition 10s, a-C:H deposition 10s.

For each polymer film, the oxygen transmission rate (OTR) and water transmission rate (WTR) were then measured at two locations. Two un-coated films were also measured. For OTR, the measurements were performed using an OX-TRAN™ Model 2/61 during a period of 24 hours at 23°C and 50%RH. For WTR, the measurements were performed using an SYSTECH 7001 during a period of 24 hours at 38°C and 90%RH. Results are shown in table 2.

**Table 2**

| Sample | | OTR (cm³/m²/24h) 23°C - 50%RH -100% O₂ | | WTR (g/m²/24h) 38°C - 90%RH | |
|---|---|---|---|---|---|
| | | 1 | 2 | 1 | 2 |
| PET 12µm | Uncoated | 115 | 113 | 39.3 | 38.6 |
| | Coated | 0.7 | 0.4 | 0.21 | 0.22 |
| PP 20 µm | Uncoated | 1817 | 1840 | 8.7 | 8.6 |
| | Coated | 11.2 | 9.6 | 0.11 | 0.09 |

## Claims

1. A polymer film or polymer container coated with a gas barrier coating, wherein said gas barrier coating comprises a first layer of hydrogenated amorphous silicon nitride deposited onto said polymer film or polymer container, and a second layer of hydrogenated amorphous carbon deposited onto said hydrogenated amorphous silicon nitride layer, and wherein said gas barrier coating has a thickness of between 2 nm and 25 nm, preferably between 2 nm and 20 nm and still more preferably between 2 nm and 15 nm, with the proviso that said polymer container is not a polyolefin container.

2. A polymer film or polymer container according to claim 1, wherein said first layer of hydrogenated amorphous silicon nitride has a thickness of between 1 nm and 15 nm, and preferably between 2 nm and 10 nm.

3. A polymer container according to claim 1 or claim 2 wherein at least 99 % of the internal surface and/or at least 99 % of the external surface of the polymer container is coated with said gas barrier coating.

4. A polymer container according to any one of claims 1 to 3 wherein the container is injection-moulded.

5. A polymer film according to claim 1 or claim 2 wherein said polymer is selected from the group formed by: polyolefin (preferably polyethylene or polypropylene), polyesters (preferably polyethylene terephthalate or polybutylene terephthalate), polystyrenes (preferably polystyrene, styrene-butadiene rubber, acrylonitrile-butadiene-styrene copolymers), polyamides, polyimides, fluorinated polymers (preferably polytetrafluoroethylene, ethylene polytetrafluoroethylene, ethylene chlorotrifluoroethylene), polyvinylchloride, biopolymers (preferably polylactic acid, cellulose, starch).

6. A polymer container according to any of claims 1 to 4, wherein said polymer is selected from the group formed by: polyesters (preferably polyethylene terephthalate or polybutylene terephthalate), polystyrenes (preferably polystyrene, styrene-butadiene rubber, acrylonitrile-butadiene-styrene copolymers), polyamides, polyimides, fluorinated polymers (preferably polytetrafluoroethylene, ethylene polytetrafluoroethylene, ethylene chlorotrifluoroethylene, polyvinylchloride, biopolymers (preferably polylactic acid, cellulose, starch).

7. A polymer film according to any one of claims 1, 2 or 5, or a polymer container according to any one of claims 1 to 4 or 6, having an oxygen transfer rate per m² of container surface of less than 6 cm³ of oxygen per day at 1 bar pressure and 100% oxygen.

8. A polymer container according to any one of claims 1 to 4, 6 or 7 wherein the container is closed by a membrane sealed to the container in a gas and moisture tight manner, said membrane comprising preferably a polymer film according to any one of claims 1, 2, 5 or 7.

9. A polymer container according to any one of claims 1 to 4, 6 or 8 wherein the container is selected from the group consisting of a bottle, a tray, a cup or a capsule.

10. A process for coating a polymer film or polymer container comprising the steps:
(a) depositing a layer of hydrogenated amorphous silicon nitride on said polymer film or polymer container by plasma-enhanced chemical vapour deposition (preferably using a mixture of silane and nitrogen),
(b) depositing a layer of hydrogenated amorphous carbon on said hydrogenated amorphous silicon nitride layer by plasma-enhanced chemical vapour deposition (preferably using ethyne),
wherein said gas barrier has a thickness of between 2 nm and 25 nm, preferably between 2 nm and 20 nm, and still more preferably between 2 nm and 15 nm, with the proviso that said polymer container is not a polyolefin container.

11. A process according to claim 10, wherein said silicon nitride layer is deposited with a deposition rate comprised between 5 nm/min and 100 nm/min (and preferably between 10 nm/min and 50 nm/min), and/or said carbon layer is deposited with a deposition rate between 50 nm/min and 200 nm/min (and preferably between 75 nm/min and 200 nm/min, and still more preferably between 100 nm/min and 175 nm/min).

12. A process according to claim 10 or claim 11 further comprising pre-treating the polymer film or polymer container with a plasma of argon before deposition of the hydrogenated amorphous silicon nitride layer.

13. Use of polymer container according to any one of claims 1 to 4 or 6 to 8 for the storage of food or beverage materials.

14. Use of a polymer container according to any one of claims 1 to 4 or 7 to 9 as a film-sealed food tray.

15. Use of a polymer film according to any one of claims 1, 2, 5 or 7 for the manufacture of containers or packaging for the storage of food or beverage materials.

## Patentansprüche

1. Polymerfolie oder Polymerbehälter, der mit einer Gassperrbeschichtung beschichtet ist, wobei die Gassperrbeschichtung eine erste Schicht aus hydriertem amorphem Siliciumnitrid, die auf die Polymerfolie oder den Polymerbehälter abgeschieden ist, und eine zweite Schicht aus hydriertem amorphen Kohlenstoff umfasst, die auf die hydrierte amorphe Siliciumnitridschicht abgeschieden ist, und wobei die Gassperrbeschichtung eine Dicke zwischen 2 nm und 25 nm, vorzugsweise zwischen 2 nm und 20 nm und noch mehr bevorzugt zwischen 2 nm und 15 nm aufweist, mit der Maßgabe, dass der Polymerbehälter kein Polyolefinbehälter ist.

2. Polymerfolie oder Polymerbehälter nach Anspruch 1, wobei die erste Schicht aus hydriertem amorphem Siliciumnitrid eine Dicke zwischen 1 nm und 15 nm und vorzugsweise zwischen 2 nm und 10 nm aufweist.

3. Polymerbehälter nach Anspruch 1 oder Anspruch 2, wobei mindestens 99 % der inneren Oberfläche und/oder mindestens 99 % der äußeren Oberfläche des Polymerbehälters mit der Gassperrbeschichtung beschichtet sind.

4. Polymerbehälter nach einem der Ansprüche 1 bis 3, wobei der Behälter spritzgegossen ist.

5. Polymerfolie nach Anspruch 1 oder Anspruch 2, wobei das Polymer ausgewählt ist aus der Gruppe bestehend aus: Polyolefin (vorzugsweise Polyethylen oder Polypropylen), Polyestern (vorzugsweise Polyethylenterephthalat oder Polybutylenterephthalat), Polystyrolen (vorzugsweise Polystyrol, Styrol-Butadien-Kautschuk, AcrylnitrilButadien-Styrol-Copolymeren), Polyamiden, Polyimiden, fluorierten Polymeren (vorzugsweise Polytetrafluorethylen, Ethylenpolytetrafluorethylen, Ethylenchlortrifluorethylen), Polyvinylchlorid, Biopolymeren (vorzugsweise Polymilchsäure, Cellulose, Stärke).

6. Polymerbehälter nach einem der Ansprüche 1 bis 4, wobei das Polymer ausgewählt ist aus der Gruppe bestehend aus: Polyestern (vorzugsweise Polyethylenterephthalat oder Polybutylenterephthalat), Polystyrolen (vorzugsweise Polystyrol, Styrol-Butadien-Kautschuk, AcrylnitrilButadien-Styrol-Copolymeren) Polyamiden, Polyimiden, fluorierten Polymeren (vorzugsweise Polytetrafluorethylen, Ethylenpolytetrafluorethylen, Ethylenchlortrifluorethylen), Polyvinylchlorid, Biopolymeren (vorzugsweise Polymilchsäure, Cellulose, Stärke).

7. Polymerfolie nach einem der Ansprüche 1, 2 oder 5 oder Polymerbehälter nach einem der Ansprüche 1 bis 4 oder 6 mit einer Sauerstoffübertragungsrate pro m² Behälteroberfläche von weniger als 6 cm³ Sauerstoff pro Tag bei 1 bar Druck und 100 % Sauerstoff.

8. Polymerbehälter nach einem der Ansprüche 1 bis 4, 6 oder 7, wobei der Behälter durch eine Membran verschlossen ist, die gas- und feuchtigkeitsdicht mit dem Behälter versiegelt ist, wobei die Membran vorzugsweise eine Polymerfolie nach einem der Ansprüche 1, 2, 5 oder 7 umfasst.

9. Polymerbehälter nach einem der Ansprüche 1 bis 4, 6 oder 8, wobei der Behälter ausgewählt ist aus der Gruppe bestehend aus einer Flasche, einem Tablett, einem Becher oder einer Kapsel.

10. Verfahren zum Beschichten einer Polymerfolie oder eines Polymerbehälters, umfassend die folgenden Schritte:
(a) Abscheiden einer Schicht aus hydriertem amorphem Siliciumnitrid auf die Polymerfolie oder den Polymerbehälter durch plasmaverstärkte chemische Dampfphasenabscheidung (vorzugsweise unter Verwendung einer Mischung aus Silan und Stickstoff),
(b) Abscheiden einer Schicht aus hydriertem amorphen Kohlenstoff auf die hydrierte amorphe Siliciumnitridschicht durch plasmaverstärkte chemische Dampfphasenabscheidung (vorzugsweise unter Verwendung von Ethin),
wobei die Gassperre eine Dicke zwischen 2 nm und 25 nm, vorzugsweise zwischen 2 nm und 20 nm und noch mehr bevorzugt zwischen 2 nm und 15 nm aufweist, mit der Maßgabe, dass der Polymerbehälter kein Polyolefinbehälter ist.

11. Verfahren nach Anspruch 10, wobei die Siliciumnitridschicht mit einer Abscheidungsrate abgeschieden wird, die zwischen 5 nm/min und 100 nm/min (und vorzugsweise zwischen 10 nm/min und 50 nm/min) enthalten ist, und/oder die Kohlenstoffschicht mit einer Abscheidungsrate zwischen 50 nm/min und 200 nm/min (und vorzugsweise zwischen 75 nm/min und 200 nm/min und noch mehr bevorzugt zwischen 100 nm/min und 175 nm/min) abgeschieden wird.

12. Verfahren nach Anspruch 10 oder Anspruch 11, ferner umfassend das Vorbehandeln der Polymerfolie oder des Polymerbehälters mit einem Argonplasma vor der Abscheidung der hydrierten amorphen Siliciumnitridschicht.

13. Verwendung eines Polymerbehälters nach einem der Ansprüche 1 bis 4 oder 6 bis 8 zur Lagerung von Nahrungsmittel- oder Getränkematerialien.

14. Verwendung eines Polymerbehälters nach einem der Ansprüche 1 bis 4 oder 7 bis 9 als ein folienversiegeltes Nahrungsmitteltablett.

15. Verwendung einer Polymerfolie nach einem der Ansprüche 1, 2, 5 oder 7 für die Herstellung von Behältern oder Verpackung für die Lagerung von Nahrungsmittel- oder Getränkematerialien.

## Revendications

1. Film polymère ou récipient en polymère revêtu d'un revêtement de barrière aux gaz, dans lequel ledit revêtement de barrière aux gaz comprend une première couche de nitrure de silicium amorphe hydrogéné déposée sur ledit film polymère ou ledit récipient en polymère, et une seconde couche de carbone amorphe hydrogéné déposée sur ladite couche de nitrure de silicium amorphe hydrogéné, et dans lequel ledit revêtement de barrière aux gaz présente une épaisseur située entre 2 nm et 25 nm, de préférence entre 2 nm et 20 nm et de manière davantage préférée entre 2 nm et 15 nm, à condition que ledit récipient en polymère ne soit pas un récipient en polyoléfine.

2. Film polymère ou récipient en polymère selon la revendication 1, dans lequel ladite première couche de nitrure de silicium amorphe hydrogéné présente une épaisseur située entre 1 nm et 15 nm, et de préférence entre 2 nm et 10 nm.

3. Récipient en polymère selon la revendication 1 ou la revendication 2 dans lequel au moins 99 % de la surface interne et/ou au moins 99 % de la surface externe du récipient en polymère sont revêtus dudit revêtement de barrière aux gaz.

4. Récipient en polymère selon l'une quelconque des revendications 1 à 3 dans lequel le récipient est moulé par injection.

5. Film polymère selon la revendication 1 ou la revendication 2 dans lequel ledit polymère est sélectionné dans le groupe formé par : une polyoléfine (de préférence un polyéthylène ou un polypropylène), les polyesters (de préférence un polytéréphtalate d'éthylène ou un polytéréphtalate de butylène), les polystyrènes (de préférence un polystyrène, un caoutchouc de styrène-butadiène, les copolymères d'acrylonitrile-butadiène-styrène), les polyamides, les polyimides, les polymères fluorés (de préférence un polytétrafluoroéthylène, un éthylène polytétrafluoroéthylène, un éthylène chlorotrifluoroéthylène), un polychlorure de vinyle, les biopolymères (de préférence un polyacide lactique, une cellulose, un amidon).

6. Récipient en polymère selon l'une quelconque des revendications 1 à 4, dans lequel ledit polymère est sélectionné dans le groupe formé par : les polyesters (de préférence un polytéréphtalate d'éthylène ou un polytéréphtalate de butylène), les polystyrènes (de préférence un polystyrène, un caoutchouc de styrène-butadiène, les copolymères d'acrylonitrile-butadiène-styrène), les polyamides, les polyimides, les polymères fluorés (de préférence un polytétrafluoroéthylène, un éthylène polytétrafluoroéthylène, un éthylène chlorotrifluoroéthylène), un polychlorure de vinyle, les biopolymères (de préférence un polyacide lactique, une cellulose, un amidon).

7. Film polymère selon l'une quelconque des revendications 1, 2 ou 5, ou récipient en polymère selon l'une quelconque des revendications 1 à 4 ou 5, présentant un taux de transfert d'oxygène par m² de surface de récipient de moins de 6 cm³ d'oxygène par jour à une pression de 1 bar et à 100 % d'oxygène.

8. Récipient en polymère selon l'une quelconque des revendications 1 à 4, 6 ou 7 dans lequel le récipient est fermé par une membrane scellée au récipient d'une manière étanche aux gaz et à l'humidité, ladite membrane comprenant de préférence un film polymère selon l'une quelconque des revendications 1, 2, 5 ou 7.

9. Récipient en polymère selon l'une quelconque des revendications 1 à 4, 6 ou 8 dans lequel le récipient est sélectionné dans le groupe constitué d'une bouteille, d'un plateau, d'une tasse ou d'une capsule.

10. Procédé de revêtement d'un film polymère ou d'un récipient en polymère comprenant les étapes suivantes :
(a) le dépôt d'une couche de nitrure de silicium amorphe hydrogéné sur ledit film polymère ou ledit récipient en polymère par dépôt chimique en phase vapeur assisté par plasma (de préférence en utilisant un mélange de silane et d'azote),
(b) le dépôt d'une couche de carbone amorphe hydrogéné sur ladite couche de nitrure de silicium amorphe hydrogéné par dépôt chimique en phase vapeur assisté par plasma (de préférence en utilisant de l'éthyne),
dans lequel ladite barrière au gaz présente une épaisseur située entre 2 nm et 25 nm, de préférence entre 2 nm et 20 nm, et de manière davantage préférée entre 2 nm et 15 nm, à condition que ledit récipient en polymère ne soit pas un récipient en polyoléfine.

11. Procédé selon la revendication 10, dans lequel ladite couche de nitrure de silicium est déposée avec une vitesse de dépôt comprise entre 5 nm/minute et 100 nm/minute (et de préférence entre 10 nm/minute et 50 nm/minute), et/ou ladite couche de carbone est déposée avec une vitesse de dépôt située entre 50 nm/minute et 200 nm/minute (et de préférence entre 75 nm/minute et 200 nm/minute, et de manière davantage préférée entre 100 nm/minute et 175 nm/minute).

12. Procédé selon la revendication 10 ou la revendication 11 comprenant en outre le prétraitement du film polymère ou du récipient en polymère avec un plasma d'argon avant le dépôt de la couche de nitrure de silicium amorphe hydrogéné.

13. Utilisation d'un récipient en polymère selon l'une quelconque des revendications 1 à 4 ou 6 à 8 pour le stockage de substances de type aliment ou boisson.

14. Utilisation d'un récipient en polymère selon l'une quelconque des revendications 1 à 4 ou 7 à 9 comme plateau pour produits alimentaires scellé avec un film.

15. Utilisation d'un film polymère selon l'une quelconque des revendications 1, 2, 5 ou 7 pour la fabrication de récipients ou d'emballage pour le stockage de substances de type aliment ou boisson.
